(19) Europäisches Patentamt
European Patent Office
Office européen des brevets

(11) **EP 3 985 710 A1**

(12) **EUROPEAN PATENT APPLICATION**

(43) Date of publication:
**20.04.2022 Bulletin 2022/16**

(21) Application number: **20202039.2**

(22) Date of filing: **15.10.2020**

(51) International Patent Classification (IPC):
*H01J 37/04* *(2006.01)*    *H01J 37/317* *(2006.01)*

(52) Cooperative Patent Classification (CPC):
**H01J 37/04; H01J 37/3177;** H01J 2237/0435

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventor: **WIELAND, Marco, Jan-Jaco
5500 AH Veldhoven (NL)**

(74) Representative: **ASML Netherlands B.V.
Corporate Intellectual Property
P.O. Box 324
5500 AH Veldhoven (NL)**

(54) **APERTURE PATTERNS FOR DEFINING MULTI-BEAMS**

(57)    Disclosed herein is an aperture array configured to define sub-beams that are scanned in a scanning direction in a charged particle apparatus, the aperture array comprising a plurality of apertures arranged in an aperture pattern that comprises: a plurality of parallel aperture rows, wherein apertures are arranged along the aperture rows and the aperture rows are inclined relative to the scanning direction; an edge aperture row defining an edge of the aperture pattern; and an adjacent aperture row adjacent the edge row; wherein the edge aperture row and the adjacent aperture row each comprise fewer apertures than another aperture row of the aperture pattern.

## Fig. 8

## Description

FIELD

The embodiments provided herein generally relate the generation of sub-beams in a charged particle apparatus. Embodiments provide patterns of apertures in an aperture array for generating a multi-beam of charged particles when the aperture array is illuminated by a charged particle beam. Embodiments may generate a multi-beam that comprises a large number of sub-beams and is suitable for use in a continuous scan mode.

BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an import process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

Another application for a charged particle beam is lithography. The charged particle beam reacts with a resist layer on the surface of a substrate. A desired pattern in the resist can be created by controlling the locations on the resist layer that the charged particle beam is directed towards.

A charged particle apparatus may be an apparatus for generating, illuminating, projecting and/or detecting one or more beams of charged particles. There is a general need to improve on known techniques for generating a multi-beam of charged particles in a charged particle apparatus.

SUMMARY

A sample may be illuminated by a multi-beam of charged particles. Scanning the sample with a multi-beam of charged particles may substantially reduce the time required to process the sample. An aperture array may be used to generate a multi-beam of charged particles. A surface of an aperture array may be illuminated by a single charged particle beam. Each of the plurality of apertures in the aperture array may define a sub-beam that is emitted in a multi-beam from the aperture array.

Embodiments provide aperture arrays for generating multi-beams of charged particles for use in a continuous scan process. The arrangement of apertures in each aperture array generates a multi-beam with a high packing density of sub-beams. A large number of sub-beams may therefore be generated from an illuminating charged particle beam. When the multi-beam is used in a continuous scan process, the scan lines formed on the sample by the sub-beams are non-overlapping, parallel and equally spaced.

According to a first aspect of the invention, there is provided an aperture array configured to define sub-beams that are scanned in a scanning direction in a charged particle apparatus, the aperture array comprising a plurality of apertures arranged in an aperture pattern that comprises: a plurality of parallel aperture rows, wherein apertures are arranged along the aperture rows and the aperture rows are inclined relative to the scanning direction; an edge aperture row defining an edge of the aperture pattern; and an adjacent aperture row adjacent the edge row; wherein the edge aperture row and the adjacent aperture row each comprise fewer apertures than another aperture row of the aperture pattern.

According to a second aspect of the invention, there is provided an aperture array configured to define sub-beams that are scanned in a scanning direction in a charged particle apparatus, the aperture array comprising a plurality of apertures arranged in an aperture pattern that comprises a plurality of parallel aperture rows, apertures being arranged along each aperture row; wherein the separation between adjacent apertures of different aperture rows differs.

According to a third aspect of the invention, there is provided an aperture array configured to define sub-beams that are scanned in a scanning direction in a charged particle apparatus, the aperture array comprising a plurality of apertures arranged in an aperture pattern that comprises a plurality of parallel aperture rows angled relative to the scanning direction, apertures being arranged along each aperture row; the aperture pattern having a middle set of aperture rows between two side sets of aperture rows, the side sets of aperture rows being on opposite sides of the middle set of aperture rows; wherein the number of apertures in an aperture row of the side sets is fewer than the number of apertures in an aperture row of the middle set.

According to a fourth aspect of the invention, there is provided an aperture array configured to define sub-beams that are scanned in a scanning direction in a charged particle apparatus, the aperture array comprising a plurality of apertures arranged in an aperture pattern that comprises a plurality of parallel aperture rows, apertures being arranged along each aperture row, the aperture rows being arranged in a middle set of aperture rows and two side sets of aperture rows being on opposite sides of the middle set of aperture rows; wherein, when the aperture array is scanned over a target surface, the side sets comprise an aperture row that cumulates together so that the cumulative number of apertures in the two rows is equivalent to the number of apertures of an aperture row of the middle set.

According to a fifth aspect of the invention, there is provided an aperture array configured to define sub-beams in a charged particle apparatus, wherein the sub-beams are scanned in successive scans in a scanning direction across a sample surface, the aperture array comprising a plurality of apertures arranged in an aperture pattern that comprises a plurality of parallel aperture rows, apertures being arranged along each aperture row, the aperture rows being arranged in a middle set of aperture rows, and two side sets of aperture rows being on opposite sides of the middle set; wherein the aperture pattern is configured such that a scanned region by the aperture rows of one of the side sets overlaps with, and is, the same scanned region scanned by the other of the side sets of an adjoining scan so that a aperture row of the two side sets cumulates together.

According to a sixth aspect of the invention, there is provided a charged particle apparatus comprising: a source of charged particles; and an aperture array according to any of the first to fifth aspects, wherein: the source is configured to direct a beam of charged particles towards the aperture array so that a multi-beam is emitted from the aperture array; and the charged particle apparatus is arranged to scan a sample with the multi-beam in a linear scanning direction.

According to a seventh aspect of the invention, there is provided a method of scanning a sample with a multi-beam of charged particles, the method comprising: generating a multi-beam of charged particles by illuminating an aperture array according to any of the first to fifth aspects with a charged particle beam; and scanning a sample with the generated multi-beam in a plurality of continuous and partially overlapping scans.

Other advantages of the present invention will become apparent from the following description taken in conjunction with the accompanying drawings wherein are set forth, by way of illustration and example, certain embodiments of the present invention.

BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary charged particle beam inspection apparatus.
FIG. 2 is a schematic diagram illustrating an exemplary multi-beam apparatus that is part of the exemplary charged particle beam inspection apparatus of FIG. 1.
FIG. 3 is a schematic diagram of exemplary multi-beam apparatus illustrating an exemplary configuration of source conversion unit of the exemplary charged particle beam inspection apparatus of FIG. 1.
FIG. 4A shows a known aperture pattern.
FIG. 4B shows a known aperture pattern.
FIGS. 5A and 5B show an aperture pattern according to an embodiment.
FIG. 6 shows a middle set of aperture rows according to an embodiment;
FIG. 7 shows a middle set of aperture rows as well as first and second side sets of aperture rows according to an embodiment.
FIG. 8 shows a middle set of aperture rows as well as first and second side sets of aperture rows according to an embodiment, with the first and second side sets of aperture rows moved to within a beam area.
FIG. 9 shows scan lines generated by three continuous and overlapping linear scans of a multi-beam, with the multi-beam generated by an aperture array with an aperture pattern according to an embodiment.
FIG. 10 shows a middle set of aperture rows according to an embodiment.
FIG. 11 shows a middle set of aperture rows as well as first and second side sets of aperture rows according to an embodiment.
FIG. 12 shows a middle set of aperture rows as well as first and second side sets of aperture rows according to an embodiment, with the first and second side sets of aperture rows moved to within a beam area.
FIG. 13 is a flowchart of a method according to an embodiment.

DESCRIPTION OF EMBODIMENTS

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The reduction of the physical size of devices, and enhancement of the computing power of electronic devices may be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" may cause device failure. The goal of the manufacturing process is to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

While high process yield is desirable in an IC chip manufacturing facility, maintaining a high substrate (i.e. wafer) throughput, defined as the number of substrates processed per hour, is also essential. High process yield and high substrate throughput may be impacted by the presence of a defect. This is especially if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises an scanning device and a detector apparatus. The scanning device comprises an illumination apparatus that comprises an electron source, for generating primary electrons, and a projection apparatus for scanning a sample, such as a substrate, with one or more focused beams of primary electrons. The primary electrons interact with the sample and generate interaction products, such as secondary electrons and/or backscattered electrons. The detection apparatus captures the secondary electrons and/or backscattered electrons from the sample as the sample is scanned so that the SEM may create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam may scan different parts of a sample simultaneously. A multi-beam inspection apparatus may therefore inspect a sample at a much higher speed than a single-beam inspection apparatus.

In a multi-beam inspection apparatus, the paths of some of the primary electron beams are displaced away from the central axis, i.e. a mid-point of the primary electron-optical axis (also referred to herein as the charged particle axis), of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations that cause the resulting image to be blurry and out-of-focus. An example is spherical aberrations which bring the focus of each sub-beam path into a different focal plane. In particular, for sub-beam paths that are not on the central axis, the change in focal plane in the sub-beams is greater with the radial displacement from the central axis. Such aberrations and de-focus effects may remain associated with the secondary electrons from the target when they are detected, for example the shape and size of the spot formed by the sub-beam on the target will be affected. Such aberrations therefore degrade the quality of resulting images that are created during inspection.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

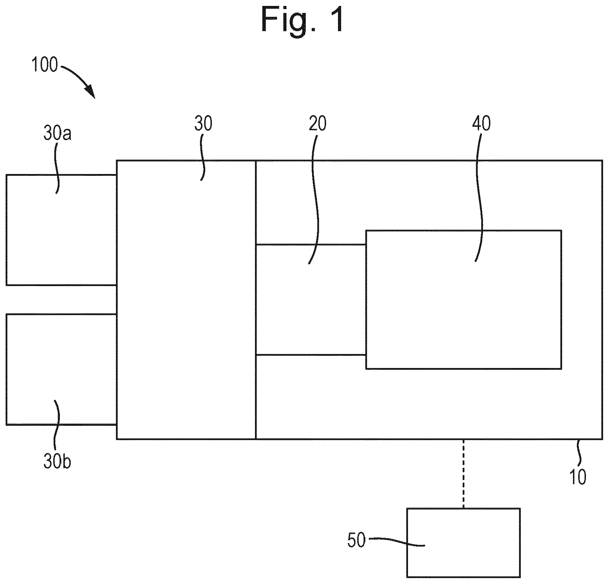

Reference is now made to **FIG. 1**, which is a schematic diagram illustrating an exemplary charged particle beam inspection apparatus 100. The charged particle beam inspection apparatus 100 of Fig. 1 includes a main chamber 10, a load lock chamber 20, an electron beam tool 40, an equipment front end module (EFEM) 30 and a controller 50.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas molecules in main chamber 10 so that the pressure around the sample reaches a second pressure lower than the first pressure. After reaching the second pressure, the sample is transported to the electron beam tool by which it may be inspected. An electron beam tool 40 may comprise either a single beam or a multi-beam electron-optical apparatus.

Controller 50 is electronically connected to electron beam tool 40. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it may be distributed over at least two of the component elements. While the present disclosure provides examples of main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

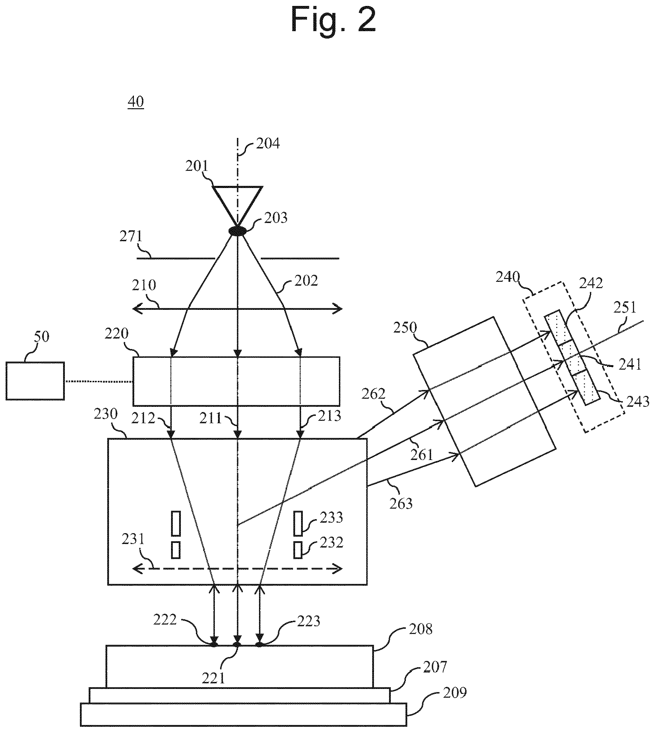

Reference is now made to **FIG. 2**, which is a schematic diagram illustrating an exemplary electron beam tool 40 including a multi-beam inspection tool that is part of the exemplary charged particle beam inspection apparatus 100 of **FIG. 1**. Multi-beam electron beam tool 40 (also referred to herein as apparatus 40) comprises an electron source 201, a gun aperture plate 271, a condenser lens 210, a source conversion unit 220, a primary projection apparatus 230, a motorized stage 209, and a sample holder 207. The electron source 201, a gun aperture plate 271, a condenser lens 210, a source conversion unit 220 are the components of an illumination apparatus comprised by the multi-beam electron beam tool 40. The sample holder 207 is supported by motorized stage 209 so as to hold a sample 208 (e.g., a substrate or a mask) for inspection. Multi-beam electron beam tool 40 may further comprise a secondary projection apparatus 250 and an associated electron detection device 240. Primary projection apparatus 230 may comprise an objective lens 231. Electron detection device 240 may comprise a plurality of detection elements 241, 242, and 243. A beam separator 233 and a deflection scanning unit 232 may be positioned inside primary projection apparatus 230.

The components that are used to generate a primary beam may be aligned with a primary electron-optical axis of the apparatus 40. These components may include: the electron source 201, gun aperture plate 271, condenser lens 210, source conversion unit 220, beam separator 233, deflection scanning unit 232, and primary projection apparatus 230. Secondary projection apparatus 250 and its associated electron detection device 240 may be aligned with a secondary electron-optical axis 251 of apparatus 40.

The primary electron-optical axis 204 is comprised by the electron-optical axis of the of the part of electron beam tool 40 that is the illumination apparatus. The secondary electron-optical axis 251 is the electron-optical axis of the of the part of electron beam tool 40 that is a detection apparatus. The primary electron-optical axis 204 may also be referred to herein as the primary optical axis (to aid ease of reference) or charged particle optical axis. The secondary electron-optical axis 251 may also be referred to herein as the secondary optical axis or the secondary charged particle optical axis.

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form a primary electron beam 202 that forms a primary beam crossover (virtual or real) 203. Primary electron beam 202 may be visualized as being emitted from primary beam crossover 203.

The formed primary electron beam 202 may be a single beam and a multi-beam may be generated from the single beam. At different locations along the beam path, the primary electron beam 202 may therefore be either a single beam or a multi-beam. By the time it reaches the sample, and preferably before it reaches the projection apparatus, the primary electron beam 202 is a multi-beam. Such a multi-beam may be generated from the primary electron beam in a number of different ways. For example, the multi-beam may be generated by a multi-beam array located before the cross-over 203, a multi-beam array located in the source conversion unit 220, or a multi-beam array located at any point in between these locations. A multi-beam array may comprise a plurality of electron beam manipulating elements arranged in an array across the beam path. Each manipulating element may influence at least part of the primary electron beam to generate a sub-beam. Thus the multi-beam array interacts with an incident primary beam path to generate a multi-beam path down-beam of the multi-beam array. The interaction of the multi-beam array with the primary beam may include one or more aperture arrays, individual deflectors e.g. per sub-beam, lenses, stigmators and (aberration) correctors, again e.g. per sub-beam.

Gun aperture plate 271, in operation, is configured to block off peripheral electrons of primary electron beam 202 to reduce Coulomb effect. The Coulomb effect may enlarge the size of each of probe spots 221, 222, and 223 of primary sub-beams 211, 212, 213, and therefore deteriorate inspection resolution. A gun aperture plate 271 may also include multiple openings for generating primary sub-beams (not shown) even before the source conversion unit 220 and may be referred to as a coulomb aperture array.

Condenser lens 210 is configured to focus (or collimate) primary electron beam 202. In an embodiment, the condenser lens 210 may be designed to focus (or collimate) primary electron beam 202 to become a substantially parallel beam and be substantially normally incident onto source conversion unit 220. Condenser lens 210 may be a movable condenser lens that may be configured so that the position of its principle plane is movable. In an embodiment, the movable condenser lens may be configured to physically move, e.g. along the optical axis 204. Alternatively, the movable condenser lens may be constituted of two or more electro-optical elements (lenses) in which the principle plane of the condenser lens moves with a variation of the strength of the individual electro-optical elements. The (movable) condenser lens may be configured to be magnetic, electrostatic or a combination of magnetic and electrostatic lenses. In a further embodiment, the condenser lens 210 may be an anti-rotation condenser lens. The anti-rotation condenser lens may be configured to keep the rotation angles unchanged when the focusing power (collimating power) of condenser lens 210 is changed and/or when the principle plane of the condenser lens moves.

In an embodiment of the source conversion unit 220, the source conversion unit 220 may comprise an image-forming element array, an aberration compensator array, a beam-limit aperture array, and a pre-bending micro-deflector array. The pre-bending micro-deflector array may, for example, be optional and may be present in an embodiment in which the condenser lens does not ensure substantially normal incidence of sub-beams originating from the coulomb aperture array onto e.g. the beam-limit aperture array, the image-forming element array, and/or the aberration compensator array. The image-forming element array may be configured to generate the plurality of sub-beams in the multi-beam path, i.e. primary sub-beams 211, 212, 213. The image forming element array may, for example, comprise a plurality electron beam manipulators such as micro-deflectors micro-lenses (or a combination of both) to influence the plurality of primary sub-beams 211, 212, 213 of primary electron beam 202 and to form a plurality of parallel images (virtual or real) of primary beam crossover 203, one for each of the primary sub-beams 211, 212, and 213. The aberration compensator array may, for example, comprise a field curvature compensator array (not shown) and an astigmatism compensator array (not shown). The field curvature compensator array may, for example, comprise a plurality of micro-lenses to compensate field curvature aberrations of the primary sub-beams 211, 212, and 213. The astigmatism compensator array may comprise a plurality of micro-stigmators to compensate astigmatism aberrations of the primary sub-beams 211, 212, and 213. The beam-limit aperture array may be configured to define the diameters of individual primary sub-beams 211, 212, and 213. FIG. 2 shows three primary sub-beams 211, 212, and 213 as an example, and it should be understood that source conversion unit 220 may be configured to form any number of primary sub-beams. Controller 50 may be connected to various parts of charged particle beam inspection apparatus 100 of FIG. 1, such as source conversion unit 220, electron detection device 240, primary projection apparatus 230, or motorized stage 209. As explained in further detail below, controller 50 may perform various image and signal processing functions. Controller 50 may also generate various control signals to govern operations of the charged particle beam inspection apparatus, including the charged particle multi-beam apparatus.

Condenser lens 210 may further be configured to adjust electric currents of primary sub-beams 211, 212, 213 down-beam of source conversion unit 220 by varying the focusing power (collimating power) of condenser lens 210. Alternatively, or additionally, the electric currents of the primary sub-beams 211, 212, 213 may be changed by altering the radial sizes of beam-limit apertures within the beam-limit aperture array corresponding to the individual primary sub-beams.

Objective lens 231 may be configured to focus sub-beams 211, 212, and 213 onto the sample 208 for inspection and, in the current embodiment, may form three probe spots 221, 222, and 223 on the surface of sample 208.

Beam separator 233 may be, for example, a Wien filter comprising an electrostatic dipole field and a magnetic dipole field (not shown in FIG. 2). In operation, beam separator 233 may be configured to exert an electrostatic force by electrostatic dipole field on individual electrons of primary sub-beams 211, 212, and 213. In an embodiment, the electrostatic force is equal in magnitude but opposite in direction to the magnetic force exerted by magnetic dipole field of beam separator 233 on the individual primary electrons of the primary sub-beams 211, 212, and 213. Primary sub-beams 211, 212, and 213 may therefore pass at least substantially straight through beam separator 233 with at least substantially zero deflection angles. The direction of the magnetic force depends on the direction of motion of the electrons while the direction of the electrostatic force does not depend on the direction of motion of the electrons. So because the secondary electrons and backscattered electrons generally move in an opposite direction compared to the primary electrons, the magnetic force exerted on the secondary electrons and backscattered electrons will no longer cancel the electrostatic force and as a result the secondary electrons and backscattered electrons moving through the beam separator 233 will be deflected away from the optical axis 204.

Deflection scanning unit 232, in operation, is configured to deflect primary sub-beams 211, 212, and 213 to scan probe spots 221, 222, and 223 across individual scanning areas in a section of the surface of sample 208. In response to incidence of primary sub-beams 211, 212, and 213 or probe spots 221, 222, and 223 on sample 208, electrons are generated from the sample 208 which include secondary electrons and backscattered electrons. In the current embodiment, the secondary electrons propagate in three secondary electron beams 261, 262, and 263. The secondary electron beams 261, 262, and 263 typically have secondary electrons (having electron energy $\leq$ 50eV) and may also have at least some of the backscattered electrons (having electron energy between 50eV and the landing energy of primary sub-beams 211, 212, and 213). The beam separator 233 is arranged to deflect the path of the secondary electron beams 261, 262, and 263 towards the secondary projection apparatus 250. The secondary projection apparatus 250 subsequently focuses the path of secondary electron beams 261, 262, and 263 onto a plurality of detection regions 241, 242, and 243 of electron detection device 240. The detection regions may, for example, be the separate detection elements 241, 242, and 243 that are arranged to detect corresponding secondary electron beams 261, 262, and 263. The detection regions may generate corresponding signals which are, for example, sent to controller 50 or a signal processing system (not shown), e.g. to construct images of the corresponding scanned areas of sample 208.

The detection elements 241, 242, and 243 may detect the corresponding secondary electron beams 261, 262, and 263. On incidence of secondary electron beams with the detection elements 241, 242 and 243, the elements may generate corresponding intensity signal outputs (not shown). The outputs may be directed to an image processing system (e.g., controller 50). Each detection element 241, 242, and 243 may comprise one or more pixels. The intensity signal output of a detection element may be a sum of signals generated by all the pixels within the detection element.

The controller 50 may comprise image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled to the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, may be used in combination with corresponding scan path data of each of primary sub-beams 211, 212, and 213 incident on the sample surface, to reconstruct images of the sample structures under inspection. The reconstructed images may be used to reveal various features of the internal or external structures of sample 208. The reconstructed images m thereby be used to reveal any defects that may exist in the sample.

The controller 50 may, e.g. further control the motorized stage 209 to move the sample 208 during, before or after inspection of the sample 208. In an embodiment, the controller 50 may enable the motorized stage 209 to move sample 208 in a direction, e.g. continuously, for example at a constant speed, at least during sample inspection. The controller 50 may control movement of the motorized stage 209 so that the speed of the movement of the sample 208 changes, e.g. dependent on various parameters. For example, the controller may control the stage speed (including its direction) depending on the characteristics of the inspection steps of scanning process.

Although **FIG. 2** shows that apparatus 40 uses three primary electron sub-beams, it is appreciated that apparatus 40 may use two or more number of primary electron sub-beams. The present disclosure does not limit the number of primary electron beams used in apparatus 40.

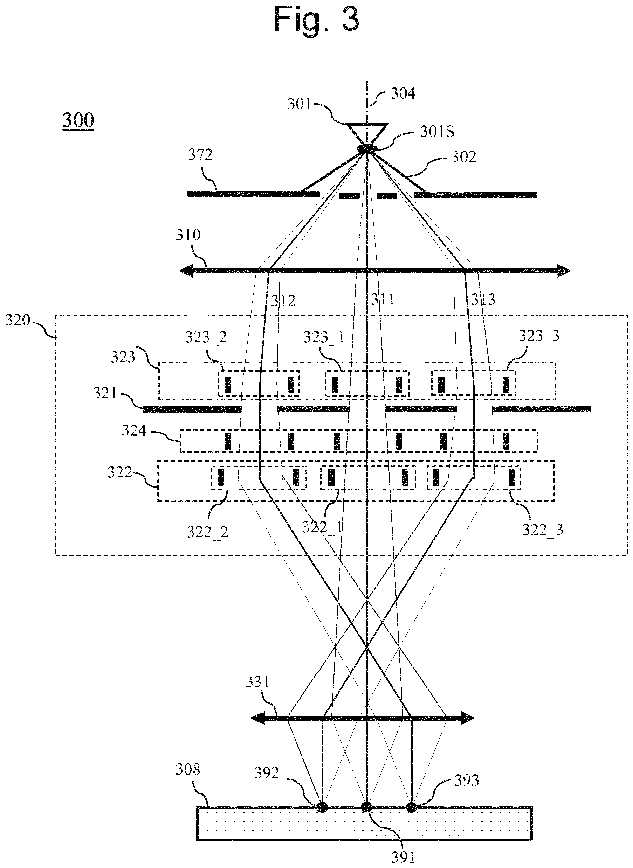

Reference is now made to **FIG. 3**, which is a schematic diagram of exemplary multi-beam apparatus illustrating an exemplary configuration of source conversion unit of the exemplary charged particle beam inspection apparatus of **FIG. 1**. The apparatus 300 may comprise an election source 301, a pre-sub-beam-forming aperture array 372 (further also referred to as coulomb aperture array 372), a condenser lens 310 (similar to condenser lens 210 of **FIG. 2**), a source conversion unit 320, an objective lens 331 (similar to objective lens 231 of **FIG. 2**), and a sample 308 (similar to sample 208 of **FIG. 2**). The election source 301, the coulomb aperture array 372, the condenser lens 310 may be the components of an illumination apparatus comprised by the apparatus 300. The source conversion unit 320 and objective lens 331 may be the components of a projection apparatus comprised by the apparatus 300. The source conversion unit 320 may be similar to source conversion unit 220 of **FIG. 2** in which the image-forming element array of **FIG. 2** is image-forming element array 322, the aberration compensator array of **FIG. 2** is aberration compensator array 324, the beam-limit aperture array of **FIG. 2** is beamlet-limit aperture array 321, and the pre-bending micro-deflector array of **FIG. 2** is pre-bending micro-deflector array 323. The election source 301, the coulomb aperture array 372, the condenser lens 310, the source conversion unit 320, and the objective lens 331 are aligned with a primary electron-optical axis 304 of the apparatus. The electron source 301 generates a primary-electron beam 302 generally along the primary electron-optical axis 304 and with a source crossover (virtual or real) 301S. The coulomb aperture array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the coulomb aperture array 372 of a pre-sub-beam-forming mechanism. Although three sub-beams and their paths are referred to in the previous and following description, it should be understood that the description is intended to apply an apparatus, tool, or system with any number of sub-beams.

The source conversion unit 320 may include a beamlet-limit aperture array 321 with beam-limit apertures configured to define the outer dimensions of the sub-beams 311, 312, and 313 of the primary electron beam 302. The source conversion unit 320 may also include an image-forming element array 322 with image-forming micro-deflectors, 322_1, 322_2, and 322_3. There is a respective micro-deflector associated with the path of each sub-beam. The micro-deflectors 322_1, 322_2, and 322_3 are configured to deflect the paths of the sub-beams 311, 312, and 313 towards the electron-optical axis 304. The deflected sub-beams 311, 312 and 313 form virtual images (not shown) of source crossover 301S. In the current embodiment, these virtual images are projected onto the sample 308 by the objective lens 331 and form probe spots thereon, which are the three probe spots, 391, 392, and 393. Each probe spot corresponds to the location of incidence of a sub-beam path on the sample surface. The source conversion unit 320 may further comprise an aberration compensator array 324 configured to compensate aberrations that may be present in each of the sub-beams. The aberration compensator array 324 may, for example, include a field curvature compensator array (not shown) with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The source conversion unit 320 may further comprise a pre-bending micro-deflector array 323 with pre-bending micro-deflectors 323_1, 323_2, and 323_3 to bend the sub-beams 311, 312, and 313 respectively. The pre-bending micro-deflectors 323_1, 323_2, and 323_3 may bend the path of the sub-beams onto the beamlet-limit aperture array 321. In an embodiment, the pre-bending micro-deflector array 323 may be configured to bend the sub-beam path of sub-beams towards the orthogonal of the plane of on beamlet-limit aperture array 321. In an alternative embodiment the condenser lens 310 may adjust the path direction of the sub-beams onto the beamlet-limit aperture array 321. The condenser lens 310 may, for example, focus (collimate) the three sub-beams 311, 312, and 313 to become substantially parallel beams along primary electron-optical axis 304, so that the three sub-beams 311, 312, and 313 incident substantially perpendicularly onto source conversion unit 320, which may correspond to the beamlet-limit aperture array 321. In such alternative embodiment the pre-bending micro-deflector array 323 may not be necessary.

The image-forming element array 322, the aberration compensator array 324, and the pre-bending micro-deflector array 323 may comprise multiple layers of sub-beam manipulating devices, some of which may be in the form or arrays, for example: micro-deflectors, micro-lenses, or micro-stigmators.

In the current example of the source conversion unit 320, the sub-beams 311, 312 and 313 of the primary electron beam 302 are respectively deflected by the micro-deflectors 322_1, 322_2 and 322_3 of image-forming element array 322 towards the primary electron-optical axis 304. It should be understood that the sub-beam 311 path may already correspond to the electron-optical axis 304 prior to reaching micro-deflector 322_1, accordingly the sub-beam 311 path may not be deflected by micro-deflector 322_1.

The objective lens 331 focuses the sub-beams onto the surface of the sample 308, i.e., it projects the three virtual images onto the sample surface. The three images formed by three sub-beams 311 to 313 on the sample surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393.

In the embodiment of a multi-beam inspection tool 300 as shown in Fig. 3 the beam path of the secondary electrons, beam separator (similar as Wien filter 233), secondary projection optics (similar as secondary projection optics 250 of Fig. 2) and electron detection device (similar as electron detection device 240) have been omitted for clarity reasons. Is should be clear however that similar beam separator, secondary projection optics and electron detection device may be present in the current embodiment of Fig. 3 to register and generate an image of the sample surface using the secondary electrons or backscattered electrons.

At least some of the above-described components in **FIG. 2** and **FIG. 3** may individually, or in combination with each other, be referred to as a manipulator array, or manipulator, because they manipulate one or more beams, or sub-beams, of charged particles.

The above described embodiments of multi-beam inspection tools comprise a multi-beam charged particle apparatus, that may be referred to as a multi-beam charged particle optical apparatus, with a single source of charged particles. The multi-beam charged particle apparatus comprises an illumination apparatus and a projection apparatus. The illumination apparatus may generate a multi-beam of charged particles from the beam of electrons from the source. The projection apparatus projects a multi-beam of charged particles towards a sample. At least part of the surface of a sample may be scanned with the multi-beam of charged particles.

A multi-beam charged particle apparatus comprises one or more electron-optical devices for manipulating the sub-beams of the multi-beam of charged particles. The applied manipulation may be, for example, a deflection of the paths of sub-beams and/or a focusing operation applied to the sub-beams. The one or more electron-optical devices may comprise MEMS.

The charged particle apparatus may comprise beam path manipulators located up-beam of the electron-optical device and, optionally, in the electron-optical device. Beam paths may be manipulated linearly in directions orthogonal to the charged particle axis, i.e. optical axis, by, for example, two electrostatic deflector sets operating across the whole beam. The two electrostatic deflector sets may be configured to deflect the beam path in orthogonal directions. Each electrostatic deflector set may comprise two electrostatic deflectors located sequentially along the beam path. The first electrostatic deflector of each set applies a correcting deflection and the second electrostatic deflector restores the beam to the correct angle of incidence on the electron-optical device. The correcting deflection applied by the first electrostatic deflector may be an over correction so that the second electrostatic deflector can apply a deflection for ensuring the desired angle of incidence to the MEMS. The location of the electrostatic deflector sets could be at a number of locations up-beam of the electron-optical device. Beam paths may be manipulated rotationally. Rotational corrections may be applied by a magnetic lens. Rotational corrections may additionally, or alternatively, be achieved by an existing magnetic lens such as the condenser lens arrangement.

A charged particle apparatus may comprise an aperture array for generating a multi-beam of charged particles. A surface of the aperture array may be illuminated by a single charged particle beam. Each of the plurality of apertures in the aperture array may define a sub-beam that is emitted in a multi-beam from the aperture array. For example, a multi-beam may be generated by the above-described coulomb aperture array 372 or the beamlet-limit aperture array 321. The multi-beam may be used to scan a sample in, for example, an inspection or lithography process. Scanning the sample with a multi-beam may be substantially reduce the time required to process the sample.

Embodiments provide aperture arrays for generating multi-beams of charged particles for use in a scanning process. The arrangement of apertures in each aperture array generates multi-beams with a high packing density of sub-beams. A large number of sub-beams may therefore by generated from an illuminating, or incidental, charged particle beam.

There are a number of different scanning modes that may be used to scan a sample with a multi-beam. In a leap-and-scan mode, scanning is performed by illuminating a sample with a multi-beam over a first illumination area. After the imaging, or other processes, are complete for the first illumination area, the sample may be moved so that a second illumination area is illuminated by the multi-beam. This process may repeat with the sample being illuminated in discrete steps at a plurality of non-overlapping illumination areas.

In a continuous scan mode, a scan is performed continuously while a sample is moved. A scan may be performed by moving the sample in continuous linear motions under the multi-beam. The path on the sample of each sub-beam of the multi-beam formed due to relative movement between the sub-beams and the sample may be referred to as a scan line. The sample may be moved back-and-forth relative to the multi-beam so that the scan lines form a raster pattern.

In an aperture array, a plurality of apertures are arranged in a aperture pattern. The aperture pattern defines the relative location of the sub-beams in the multi-beam generated when the aperture array is illuminated. The aperture pattern should be appropriate for the scan mode that will be used.

The volume through which the illuminating beam passes may be cone shaped. The shape of the illumination area on an illuminated surface of the aperture array may therefore be circular or elliptical. In order to generate a large number of sub-beams, a substantial proportion of the illuminated area of the aperture array may be used generate sub-beams.

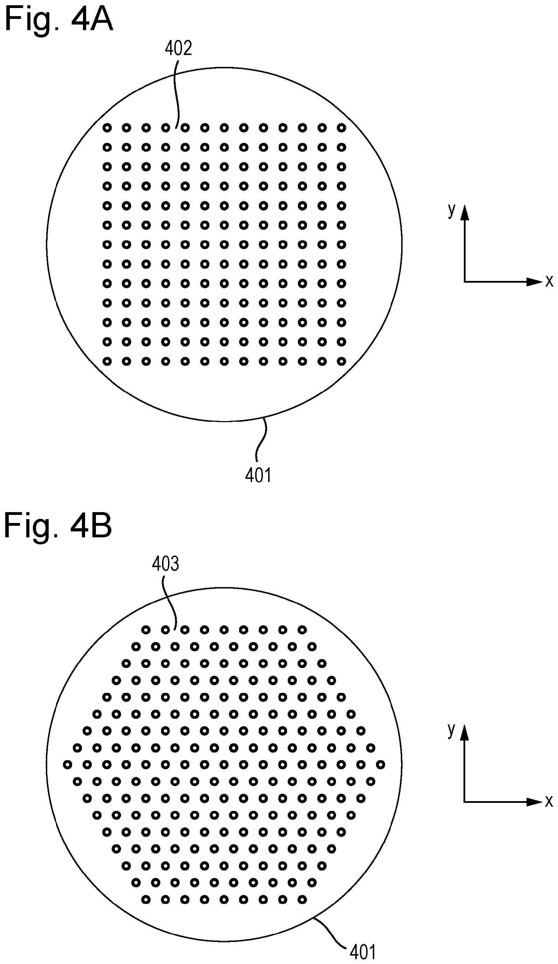

FIGS. 4A and 4B show illumination areas 401 on a surface of an aperture array. The illumination areas 401 are circular.

In FIG. 4A, the aperture pattern is a square arrangement. That is to say, each of the sub-beams in the generated multi-beam is located at a corner of a square, with nearby sub-beams located at the other corners of the square. The outer perimeter of the aperture pattern is a square. Each aperture away from the perimeter has four equidistantly spaced adjacent apertures. Each aperture away from the perimeter has four nearest neighboring apertures.

In FIG. 4B, the aperture pattern is a hexagonal arrangement. That is to say, each of the sub-beams in the generated multi-beam is located at a corner of a hexagon, with nearby sub-beams located at the other corners of the hexagon. The outer perimeter of the aperture pattern is also a hexagon. Each aperture away from the perimeter has six equidistantly spaced adjacent apertures. Each aperture away from the perimeter has six nearest neighboring apertures

The aperture pattern shown in FIG. 4B may generate more sub-beams than the aperture pattern in FIG. 4A because more of the circular illumination area is used to generate sub-beams. In addition, a hexagonal arrangement of apertures may have a larger packing density than a square arrangement of apertures. The area of a plate in which the aperture pattern is defined is greater for the hexagonal arrangement shown in Figure 4B than for the square arrangement shown in Figure 4A.

The direction of a multi-beam on approach of a sample may be defined as being substantially along a z-axis. The z-axis may be substantially aligned with the paths of the sub-beams. The illuminated surface of the sample may substantially be defined as being in the x-y plane. In a continuous scan mode, a sample may be moved linearly in the x-y plane; and not in the z-direction.

When the outer perimeter of an aperture pattern is a substantial square, or a substantial hexagon, such as in FIGS. 4A and 4B, the multi-beams generated by the aperture patterns are appropriate for use in a leap-and-scan mode. However, such beam patterns may not be suitable for use in a continuous scan mode because the scan lines of different sub-beams may overlap with each other. For example, if the sub-beams generated by the apertures shown in FIG. 4A are moved linearly in the x-direction relative to the sample the scan lines from the sub-beams in each row would all overlap with each other.

A technique for avoiding overlap of the scan lines is to rotate, or skew, the aperture pattern relative to the linear scanning direction. The sub-beams in the multi-beam may then form a plurality of non-overlapping parallel scan lines.

Another requirement is for the plurality of scan lines to all be equally spaced apart from each other. For the hexagonal pattern shown in FIG. 4B, only rotating the aperture pattern relative to the linear scanning direction may provide an unequal spacing between scan lines and the multi-beam may not be suitable for use in a continuous scan mode.

The aperture patterns according to embodiments are for generating a multi-beam for use in a continuous scan mode. The aperture patterns may have a large beam density so that a large number of sub-beams may be generated from an illumination area. The illumination area may be circular, elliptical or have another shape. The illumination area may be a planar cross-section of the beam from the source in which the aperture array is situated, preferably with which the aperture array is coplanar. The cross-section of the source beam may be referred to as a beam area; thus the beam area for the aperture array may be the illumination area. The aperture patterns are arranged so that a linear movement in the scanning direction generates parallel and non-overlapping scan lines, with an equal spacing between adjacent scan lines.

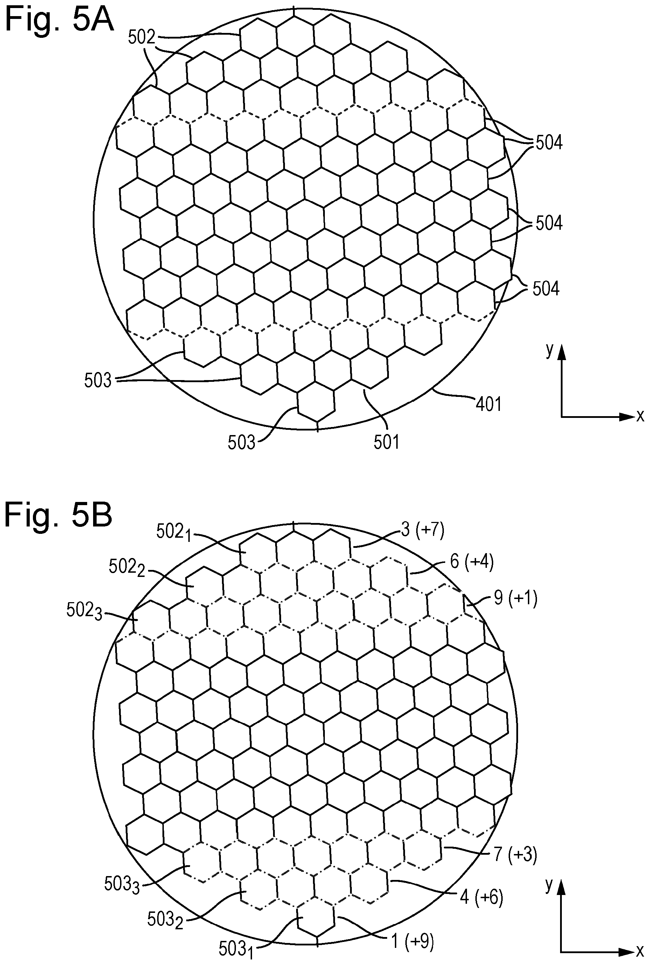

FIGS. 5A and 5B show an aperture pattern 501 according to an embodiment. The aperture pattern in FIG. 5B is the same as that in FIG. 5A but has different reference signs in order to help describe aspects of the aperture pattern. The aperture pattern is within a circular illumination area 501. The aperture pattern in FIGS. 5A and 5B may be configured to generate a multi-beam that is scanned linearly in the x-direction. As will be described in more detail later, a sample may be scanned by the multi-beam in a plurality of continuous and overlapping linear scans.

In FIGS. 5A and 5B, the location of each aperture is indicated by a hexagonal tile. The shape of the tile is used to represent a region assigned to an aperture. The aperture may be of any shape, and is typically circular. The aperture may be positioned towards the center of its corresponding tile. For example, the center of each aperture may be substantially at the center of each hexagonal tile.

The aperture pattern comprises a plurality of aperture rows. Each aperture row comprises a linear arrangement of one or more apertures. Each aperture row may be inclined relative to a linear scanning direction, which is the x-direction in FIGS. 5A and 5B. Inclining the aperture rows ensures that the scan lines of the sub-beams do not overlap with each other.

The spacing between the apertures in each aperture row may be arranged so that when the aperture array is used in a plurality of continuous and overlapping linear scans, all of the scan lines have an equal spacing. Within each aperture row, the spacing between adjacent apertures may be the same.

As shown in **FIG. 5A**, the aperture rows may be arranged in three sets. These may be a first side set 502, a middle set 504 and second side set 503. The first side set 502 and second side set 503 may be on opposite sides of the middle set 504.

In the middle set 504 of aperture rows, all of the aperture rows may comprise the same number of apertures. In the specific implementation of an embodiment shown in **FIG. 5A**, each aperture row of the middle set comprises ten apertures.

In the first side set 502 of aperture rows, each aperture row may comprise fewer apertures than an aperture row of the middle set 504. As shown in **FIG. 5B**, the aperture row $502_3$ closest to the middle set 504 may be one of the aperture rows in the first side set 502 with the largest number of apertures. Each other aperture row in the first side set 502 may have the same, or fewer, number of apertures than an adjacent aperture row in the direction of the middle set 504. In the specific implementation of an embodiment shown in **FIG. 5B**, the aperture rows $502_1$, $502_2$ and $502_3$ of the first side set 502 respectively comprise three, six and nine apertures.

In the second side set 503 of aperture rows, each aperture row may comprise fewer apertures than an aperture row of the middle set 504. The aperture row $503_3$ closest to the middle set 504 may be one of the aperture rows in the second side set 503 with the largest number of apertures. Each other aperture row in the second side set 503 may have the same, or fewer, number of apertures than an adjacent aperture row in the direction of the middle set 504. In the specific implementation of an embodiment shown in **FIG. 5B**, the aperture rows $503_1$, $503_2$ and $503_3$ of the second side set comprise one, four and seven apertures.

A multi-beam generated by the aperture array may be used in a plurality of continuous and overlapping linear scans. Each scan may be in the x-direction but located differently in the y-direction.

The first scan by the multi-beam may generate a plurality of non-overlapping and parallel scan lines. The spacing between scan lines generated by apertures in the middle set 504 may be equal. However, the spacing between some of scan lines generated by apertures in the first side set 502 and second side set 503 may be unequal.

For the subsequent scan by the multi-beam, the sample, and/or multi-beam, are shifted in the y-direction relative to the first scan. The shift in the y-direction may be selected so that the surface of the sample for the subsequent scan partially overlaps with the surface of the first scan. The shift in the y-direction is such that the scan lines generated by the second side set 503 during the subsequent scan cumulate with the scan lines generated by the first side set 502 during the first scan. That is to say, the region of the multi-beam that comprises the scan lines from the apertures in the second side set 503 overlaps with the region of the multi-beam that comprises the scan lines from the apertures in the first side set 502 during the previous scan. The regions of the first and subsequent scan overlap without the scan lines overlapping. The regions of the first and subsequent scan that overlap may be referred to as an overlap region. In the overlap region the scan lines may be equidistantly spaced apart. The scan lines in the overlap region may be spaced part by the same distance as scan lines formed by the apertures of the middle set 504.

**FIG. 5B** illustrates how the scan lines generated by the second side set 503 may cumulate with the scan lines generated by the first side set 502 during the previous scan.

In **FIG. 5B**, each row of the middle set 504 comprises ten apertures. A first row $502_1$ of the first side set 502 comprises three apertures. A second row $502_2$ of the first side set 502 comprises six apertures. A third row $502_3$ of the first side set 502 comprises nine apertures. A first row $503_1$ of the second side set 503 comprises one aperture. A second row $503_2$ of the second side set 503 comprises four apertures. A third row $503_3$ of the second side set 604 comprises seven apertures.

Each aperture row in the first side set 502 may effectively combine with a row in the second side set 503, with the combination being equivalent to a row of the middle set. In particular, the first row $502_1$ of the first side set 502 may effectively combine with the third row $503_3$ of the second side set 503 to provide a row with ten apertures (= 3+7). The second row $502_2$ of the first side set 502 may effectively combine with the second row $503_2$ of the second side set 503 to provide a row with ten apertures (= 6+4). The third row $502_3$ of the first side set 502 may effectively combine with the first row $503_1$ of the second side set 503 to provide a row with ten apertures (= 9+1).

The effect of overlapping the regions of the different side sets during consecutive scans is that the scan lines generated by apertures in the different side sets effectively combine to provide equivalent scan lines to those generated by the aperture rows in the middle set 504.

Continuous and overlapping linear scans of the multi-beam relative to the sample may generate a plurality of parallel and equally spaced scan lines on a sample.

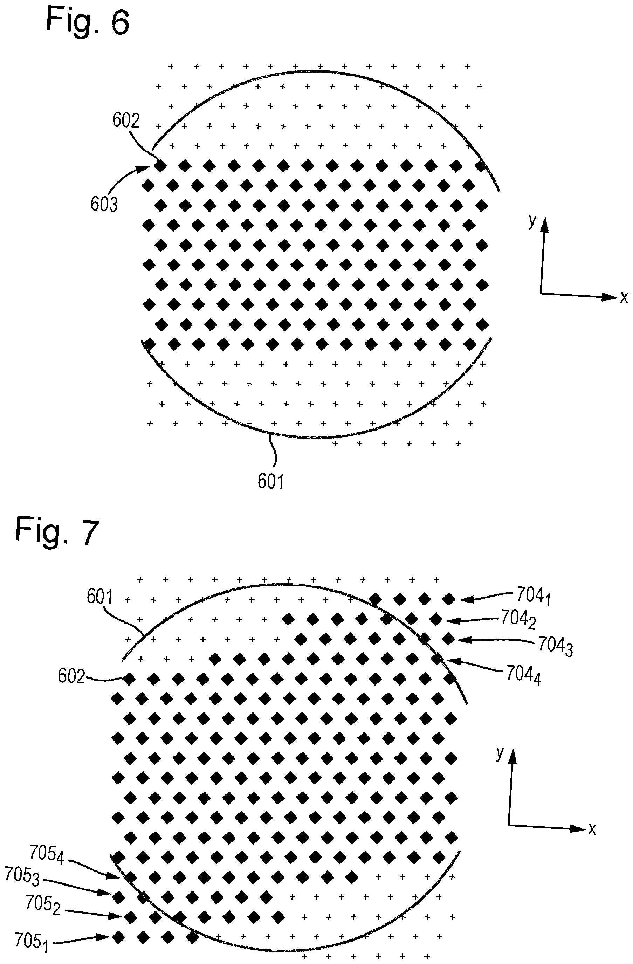

**FIGS. 6 to 8** illustrate a design process for an aperture array according to embodiments. The illumination area 601 of the aperture array is circular. However, embodiments include the design process being applied to any shape of illumination area, such as an elliptical or square shaped illumination area.

A middle set of aperture rows may be defined first as shown in **FIG. 6**. In order to maximize the beam packing density, the pitch, i.e. spacing, between adjacent apertures may be a minimum pitch possible given the manufacturing and operational constraints.

The outer perimeter of the middle set may have a substantial rectangular/square shape and be as large a possible for accommodating a substantial rectangular/square outer perimeter in the illumination area 601. The apertures may be arranged in a plurality of parallel linear rows with adjacent apertures in each row having the minimum pitch. In **FIG. 6**, aperture row 603 is an edge row of the middle set. Aperture 602 is an end aperture of aperture row 603. The apertures may be arranged in a hexagonal arrangement to the extent that each aperture is located at the corner of a hexagon with nearby apertures, for example away from the perimeter six nearest apertures, being located at the other corners of a corresponding hexagon, e.g. a hexagonal tile of **FIG. 5A.** Such a hexagonal arrangement may have a higher packing density than that of a square arrangement.

A shifting operation is then applied to some of the aperture rows and the aperture rows are then rotated by the rotation angle $\alpha$. In order to describe this process, the following definitions are used: X' = x-direction before the rotation over $\alpha$ has been applied, X = x-direction after the rotation over $\alpha$ has been applied, Y' = y-direction before the rotation over $\alpha$ has been applied, and Y = y-direction before the rotation over $\alpha$ has been applied.

A shift, in the Y'-direction, may be applied to alternate, e.g. odd numbered, aperture rows. The aperture rows may then be rotated over $\alpha$ so that each aperture row is inclined relative to the scanning direction, which is the x-direction in **FIG. 6.** The rotation prevents scan lines from different sub-beam overlapping.

The shift applied alternate aperture rows should ensure that the scan lines from different sub-beams are equally spaced apart. The applied shift may be:

$$d = \frac{p.\tan\alpha}{2}$$

where:

$d$ = the applied shift in the Y'-direction
$p$ = the pitch between adjacent apertures
$\alpha$ = the applied rotation, i.e. the angle between each aperture row and the scanning direction

A property of the apertures in the middle set of aperture rows may be that in a projection of the apertures onto a line that is in the same plane as the aperture pattern and is normal to the scanning direction (i.e. aligned with the y-axis), the spacing between each pair of adjacent projections of apertures is the same.

Each aperture row of the middle set may comprise the same number of apertures. However, each aperture row of the middle set may comprise a different number of apertures so long as, in a projection of the apertures along the y-axis (i.e. onto a line that is in the same plane as the aperture pattern and is normal to the scanning direction), the spacing between each pair of adjacent projections of apertures is the same.

The middle set comprises complete aperture rows. The scanned region on the surface of a sample by sub-beams from the middle set may be scanned only once. The scanned region may not also be scanned by sub-beams in a consecutive scan. The scanned region is a portion of the sample which prior to the scanning by the apertures of the middle set was unscanned.

The next step in the design process of the aperture pattern is to define the first and second side sets. The first and second side sets increase the used proportion of the illumination area.

A requirement of each aperture row of the first side set is that it forms a corresponding pair with an aperture row of the second side set. The aperture rows in each corresponding pair of aperture rows combine, through consecutive scans, to be equivalent to an aperture row of the middle set. Each aperture row of the first and second side sets may therefore be considered to be a part of a complete aperture row.

**FIG.** 7 shows the aperture arrangement of **FIG. 6** modified to include aperture rows in the first and second side sets. Each aperture row of the first side set may be defined as corresponding to part of one of the already defined aperture rows of the middle set but with a displacement in the +y-direction (i.e. Y'-direction) applied. Each aperture row of the second set may be defined as corresponding to part of one of the already defined aperture rows of the middle set but with a shift in the -y-direction (i.e. -Y'-direction) applied. Each corresponding pair of aperture rows may be defined as equivalent to the constituent parts of a complete aperture row of the middle set. Alternatively, or additionally, the aperture rows and of the first and second sets may be considered in pairs. An effective aperture row may have its +X' portion assigned to the first side set and its -X' portion assigned to the second side set.

The first side set comprises a first aperture row $704_1$, a second aperture row $704_2$, a third aperture row $704_3$ and a fourth aperture row $704_4$. The second side set comprises a first aperture row 705i, a second aperture row $705_2$, a third aperture row $705_3$ and a fourth aperture row $705_4$. The first aperture row $704_1$ of the first side set and the fourth aperture row $705_4$ of the second side set are a corresponding pair of aperture rows. The second aperture row $704_2$ of the first side set and the third aperture row $705_3$ of the second side set are a corresponding pair of aperture rows. The third aperture row $704_3$ of the first side set and the second aperture row $705_2$ of the second side set are a corresponding pair of aperture rows. The fourth aperture row $704_4$ of the first side set and the first aperture row $705_1$ of the second side set are a corresponding pair of aperture rows.

For each corresponding pair of aperture rows, a shift in the +y-direction (i.e. Y'-direction) of the aperture row in the second side set would result in it co-linearly aligning with the aperture row in the first side set. The magnitude of the shift in the +y-direction (i.e. Y'-direction) that is required is the same as the shift in the y-direction (i.e. Y' -direction) during a continuous scanning process between consecutive scans in the x-direction. The scan lines resulting from the aligned aperture rows from the different side sets may be equivalent those that would be generated if each aperture row of the first side set instead comprised the same number of apertures as an aperture row of the middle set. Alternatively or additionally, the two +X' and -X' portions of the pairs ($704_1$, $705_4$; $704_2$, $705_3$; $704_3$, $705_2$; $704_4$, $705_1$) may be considered equivalent to effective aperture rows and thus an aperture row of the middle set.

In the first side set, the aperture row closest to the middle set may be one of the aperture rows in the first side set with the largest number of apertures. Each other aperture row in the first side set may have the same, or fewer, number of apertures than an adjacent aperture row in the direction of the middle set.

Similarly, in the second side set, the aperture row closest to the middle set may be one of the aperture rows in the second side set with the largest number of apertures. Each other aperture row in the second side set may have the same, or fewer, number of apertures than an adjacent aperture row in the direction of the middle set.

The final step in the design process is to ensure that all of the apertures are located within the illumination area 601.

A shift is applied to each of the aperture rows in the first side set. The shift is applied in the - x-direction only (i.e. the shift is along the scanning direction). The applied shift in the -x-direction may differ between the aperture rows. Any shift in the -x-direction may be applied to each aperture row so long as all of the apertures of the aperture row are moved to within the illumination area 601.

A preferred implementation is for each aperture row in the first side set, apart from the aperture row adjacent to the middle set, to be shifted by the same amount, or more, than the adjacent aperture row in the direction of the middle set. This may result in the shifts in the -x-direction only increasing the pitch between apertures.

A shift is also applied to each of the aperture rows in the second side set. The shift is applied in the +x-direction only. The applied shift in the +x-direction may differ between the aperture rows. Any shift in the +x-direction may be applied to each aperture row so long as all of the apertures of the aperture row are moved to within the illumination area 601.

A preferred implementation is for each aperture row in the second side set, apart from the aperture row adjacent to the middle set, to be shifted by the same amount, or more, than the adjacent aperture row in the direction of the middle set. This may result in the shifts in the x-direction only increasing the pitch between apertures.

The above-described preferred implementations ensure that the pitch between adjacent apertures in the sides sets is greater than, or equal to, the pitch between adjacent apertures in the middle set. The implementations ensure that the pitch does not decrease as a result of these adjustments to the arrangement of the aperture pattern.

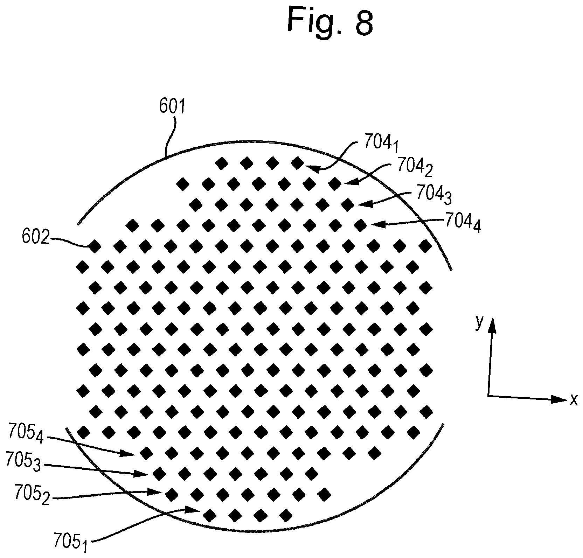

FIG. 8 shows the aperture pattern after the aperture rows of the first and second side sets have been shifted, i.e. displaced, so that all of the apertures are within the illumination area 601. This is an aperture pattern according to an embodiment.

The above described processes for constructing the aperture pattern shown in FIG. 8 have resulted in all of the aperture rows having a positive gradient relative to the x-axis. Embodiments also include similar processes with the shifts, rotation and displacements of the aperture rows applied in opposite directions to those described above. This would have generated aperture rows having a negative gradient relative to the x-axis. The generated aperture pattern would be a reflection about the y-axis of the aperture pattern shown in FIG. 8.

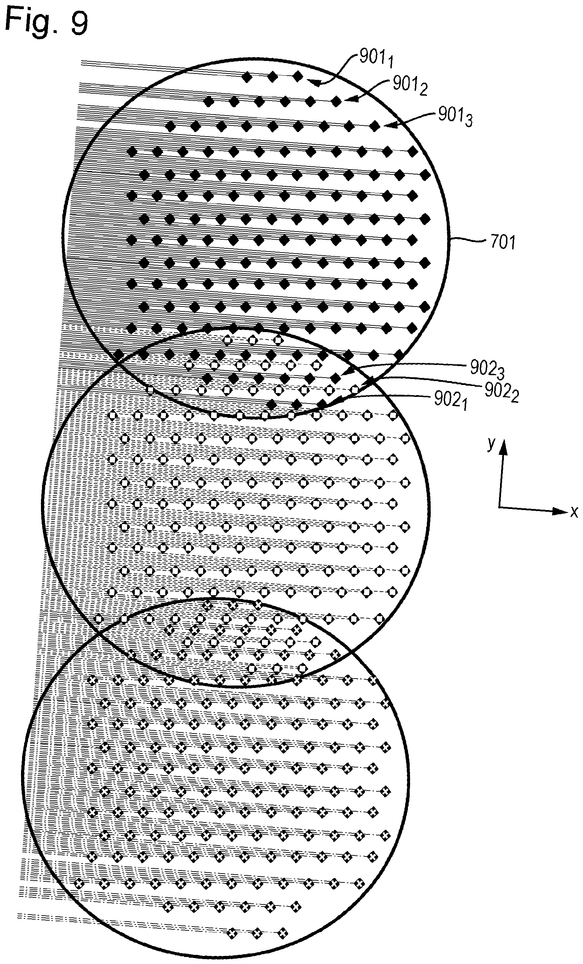

FIG. 9 shows scan lines generated by three continuous and overlapping linear scans of a multi-beam. The multi-beam has been generated by an aperture array with an aperture pattern according to an embodiment. Each scan is in the x-direction and at a different y-position. The overlapping of scanning regions in different scans may result in the main part of a scanned area being scanned by parallel and equally spaced scan lines.

The first and last scans that are performed are at the extremes along the y-axis and comprise scan lines from only one of the side sets. These scan lines may not be not equally spaced with the others. However, these non-equally spaced scan lines would be at the fringes of the total scanned area, that may be constructed from many, e.g. thousands, of consecutive scans. The scanned area of interest of a sample may be entirely within the main part of the scanned area and only scanned by equally spaced scan lines.

Embodiments include a number of variations to the above described design process of an aperture pattern.

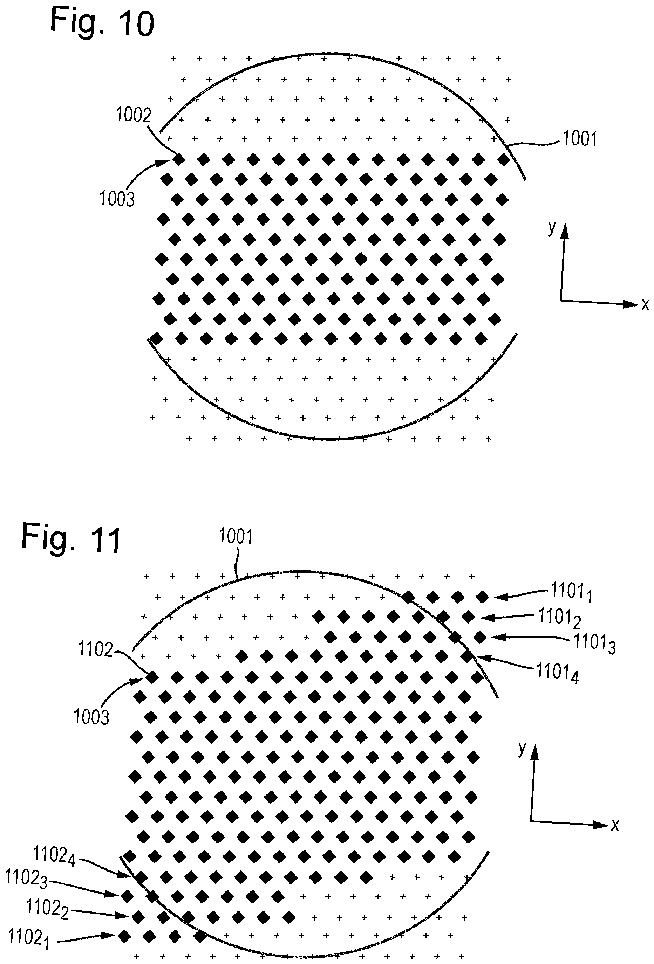

In particular, FIG. 6 shows a middle set of aperture rows that has been generated by starting with a hexagonal arrangement of aperture rows with a substantially square outer perimeter, applying shifts to alternate ones of the aperture rows and then rotating all of the aperture rows. FIGS. 10 to 12 show steps an alternative approach to generating the middle set of aperture rows.

The generation of the middle set of aperture rows may again start with a hexagonal arrangement of aperture rows with a substantially square outer perimeter. The outer perimeter of the middle set may have a substantial rectangular/square shape and be as large a possible for accommodating a substantial rectangular/square outer perimeter in the illumination area 1001.

A skew is then applied to the aperture rows to generate the middle set of aperture rows as shown in **FIG. 10**. The applied skew ensures that the scan lines from the apertures of the middle set are all non-overlapping and equally spaced. In **FIG. 10**, aperture row 1003 is an edge row of the middle set. Aperture 1002 is an end aperture of aperture row 1003.

The aperture rows of the first side set and the second side set may be generated in the same way described with reference to **FIGS. 6 to 8** so that a corresponding pair of aperture rows is equivalent to an aperture row of the middle set. **FIG. 11** shows the aperture rows of the first side set and the second side set. The first side set comprises a first aperture row $1101_1$, a second aperture row $1102_2$, a third aperture row $1103_3$ and a fourth aperture row $1104_4$. The second side set comprises a first aperture row 1102i, a second aperture row $1102_2$, a third aperture row $1102_3$ and a fourth aperture row $1102_4$.

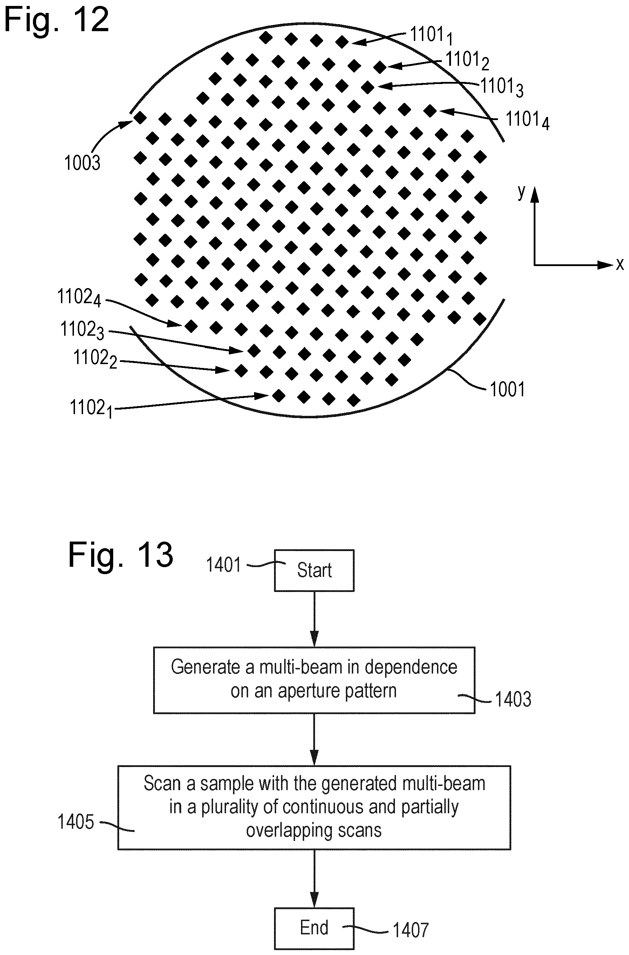

A translation in the x-direction of the aperture rows of the first side set and the second side set may be performed, in the same way described above with reference to **FIGS. 6 to 8**. The translation generates the final aperture pattern shown in **FIG. 12** in which all of the apertures are within the illumination area 1001. Continuous and overlapping linear scans of a multi-beam generated by an aperture array with the aperture pattern would also generate non-overlapping and equally spaced scan lines.

Generating the middle set of aperture rows by performing a skew may reduce the pitch between some of the apertures. A higher beam density may therefore be achievable when the middle set of aperture rows is generated by applying shifts to alternate ones of the aperture rows and then rotating all of the aperture rows.

Advantageously, embodiments provide aperture patterns that may have a high packing density and efficiently use an illumination area. A large number of sub-beams may therefore be generated from a single illuminating beam. A multi-beam generated from the aperture patterns may be used in a continuous scan mode and generate parallel and equally spaced scan lines.

**FIG. 13** is a flowchart of a process for scanning a sample with a multi-beam of charged particles according to an embodiment.

In step 1401, the process begins.

In step 1403, a multi-beam is generated in dependence on an aperture pattern according to an embodiment.

In step 1405, a sample is scanned with the generated multi-beam in a plurality of continuous and partially overlapping scans.

In step 1407, the process ends.

Embodiments include a number of modification and variations to the above-described techniques.

Embodiments also include the design processes being used to generate an aperture pattern for use with other shapes of illumination area. For example, the illumination area may be elliptical. The starting point for the middle set of aperture rows may then be a hexagonal arrangement of apertures with a substantially rectangular outer perimeter, instead of a substantially square outer perimeter. The other design steps may be substantially unchanged from as described above. Embodiments may also be used with substantially rectangular, e.g., square, or other shapes of illumination area.

Embodiments also include the starting point for the middle set of aperture rows being a square arrangement of apertures instead of a hexagonal arrangement, such as described earlier with reference to **FIG. 4A**. Such an arrangement may be preferable if the multi-beam is to be manipulated by, for example, slit deflectors and/or slit lenses.

Embodiments are not restricted to aperture patterns being generated by the above described design processes. Embodiments may generally include any aperture arrangement that defines a multi-beam that may be used to generate a plurality of non-overlapping, parallel and equally spaced scan lines from continuous and overlapping linear scans of the multi-beam.

Characteristics of an aperture pattern according to an embodiments may include one or more of:

- scan lines of sub-beams generated by apertures in the middle set have an equal spacing;
- all scan lines of sub-beams have an equal spacing in a region overlapped by consecutive scans;
- the pitch, i.e. spacing, between adjacent apertures that are each in different aperture rows varies;
- the pitch, i.e. spacing, between adjacent apertures that are each in different aperture rows of the middle set is the same, or lower, than the pitch between adjacent apertures in the first side set and/or the second side set; and
- each aperture row is inclined relative to the scanning direction.

Embodiments include there being any number of aperture rows in the middle set. For example, the number of aperture rows in the middle set may be more than 5, 10 or even more than 100 rows.

Embodiments include there being any number of apertures in each aperture row of the middle set. For example, the number of apertures in each aperture row of the middle set may be between, for example, 5 and 5000.

The multi-beam used to illuminate a sample may be generated by illuminating a single aperture array with an aperture pattern according to embodiments. This approach to generating a multi-beam may be simpler and more appropriate for achieving a high sub-beam density than nesting techniques. In nesting techniques, a first aperture array is illuminated to thereby generate a set of sub-beams. Further aperture arrays are then illuminated by each sub-beam generated by the first aperture array. The final form of the multi-beam is therefore defined by more than one aperture array.

Embodiments include the following numbered clauses:

Clause 1: An aperture array configured to define sub-beams that are scanned in a scanning direction in a charged particle apparatus, the aperture array comprising a plurality of apertures arranged in an aperture pattern that comprises: a plurality of parallel aperture rows, wherein apertures are arranged along the aperture rows and the aperture rows are inclined relative to the scanning direction; an edge aperture row defining an edge of the aperture pattern; and an adjacent aperture row adjacent the edge row; wherein the edge aperture row and the adjacent aperture row each comprise fewer apertures than another aperture row of the aperture pattern.

Clause 2: The aperture array according to clause 1, wherein: the aperture pattern comprises a middle set of aperture rows in between two side sets of aperture rows, one of the side sets of aperture rows comprising the edge aperture row and the adjacent aperture row.

Clause 3: The aperture array according to clause 2, wherein an aperture row in one of the side sets comprise fewer apertures than an aperture row in the middle set.

Clause 4: The aperture array according to clause 2 or 3, wherein, when the aperture array is scanned relative to a target surface, an aperture row from each of the side sets cumulate together to the same as the number of apertures of an aperture row of the middle set.

Clause 5: The aperture array according to any of clauses 2 to 4, wherein the distance between adjacent apertures along an aperture row of the middle set in a direction orthogonal to the scanning direction is periodic and preferably the same.

Clause 6: The aperture array according to any of clauses 2 to 5, wherein the aperture rows of the middle set comprise the same number of apertures.

Clause 7: The aperture array according to any of clauses 2 to 6, wherein, the aperture row of one or both of the side sets, and that is adjacent to the middle set, is an aperture row of the corresponding side set with the largest number of apertures.

Clause 8: The aperture array of clause 7, wherein the remaining rows of the corresponding side set has the same, or fewer, number of apertures than an adjacent aperture row in the direction of the middle set.

Clause 9: The aperture array according to any of clauses 2 to 8, wherein along the aperture rows of the middle set there are between 5 and 5000 apertures, such as 10 or 14.

Clause 10: The aperture array according to any of clauses 2 to 9, wherein along the aperture rows of the middle set there are 14 apertures; and one or more than one aperture array.

both of the side sets comprise aperture rows with 10, 7 and 4 apertures respectively.

Clause 11: The aperture array according to any preceding clause, wherein the separation between adjacent apertures in two of the aperture rows differs.

Clause 12: The aperture array according to any preceding clause, wherein the aperture pattern is within a beam area; and the beam area is substantially circular or elliptical.

Clause 13: An aperture array configured to define sub-beams that are scanned in a scanning direction in a charged particle apparatus, the aperture array comprising a plurality of apertures arranged in an aperture pattern that comprises a plurality of parallel aperture rows, apertures being arranged along each aperture row; wherein the separation between adjacent apertures of different aperture rows differs.

Clause 14: An aperture array configured to define sub-beams that are scanned in a scanning direction in a charged particle apparatus, the aperture array comprising a plurality of apertures arranged in an aperture pattern that comprises a plurality of parallel aperture rows angled relative to the scanning direction, apertures being arranged along each aperture row; the aperture pattern having a middle set of aperture rows between two side sets of aperture rows, the side sets of aperture rows being on opposite sides of the middle set of aperture rows; wherein the number of apertures in an aperture row of the side sets is fewer than the number of apertures in an aperture row of the middle set.

Clause 15: An aperture array configured to define sub-beams that are scanned in a scanning direction in a charged particle apparatus, the aperture array comprising a plurality of apertures arranged in an aperture pattern that comprises a plurality of parallel aperture rows, apertures being arranged along each aperture row, the aperture rows being arranged in a middle set of aperture rows and two side sets of aperture rows being on opposite sides of the middle set of aperture rows; wherein, when the aperture array is scanned over a target surface, the side sets comprise an aperture row that cumulates together so that the cumulative number of apertures in the two rows is equivalent to the number of apertures of an aperture row of the middle set.

Clause 16: An aperture array configured to define sub-beams in a charged particle apparatus, wherein the sub-beams are scanned in successive scans in a scanning direction across a sample surface, the aperture array comprising a plurality of apertures arranged in an aperture pattern that comprises a plurality of parallel aperture rows, apertures being arranged along each aperture row, the aperture rows being arranged in a middle set of aperture rows, and two side sets of aperture rows being on opposite sides of the middle set; wherein the aperture pattern is configured such that a scanned region by the aperture rows of one of the side sets overlaps with, and is, the same scanned region scanned by the other of the side sets of an adjoining scan so that a aperture row of the two side sets cumulates together.

Clause 17: The aperture array according to clause 16, wherein the cumulation of a scan of a row of the two side sets is equivalent to a scan of row of the middle set.

Clause 18: The aperture array according to clause 16 or 17, wherein the culmination of the number of apertures of a row of each side set is equivalent to the number of apertures of the middle set.

Clause 19: A charged particle apparatus comprising: a source of charged particles; and an aperture array according to any preceding clause, wherein: the source is configured to direct a beam of charged particles towards the aperture array so that a multi-beam is emitted from the aperture array; and the charged particle apparatus is arranged to scan a sample with the multi-beam in a linear scanning direction.

Clause 20: The charged particle apparatus according to clause 19, wherein the charged particle apparatus is arranged to operate in a continuous scan mode.

Clause 21: The charged particle apparatus according to clause 19 or 20, wherein the charged particle apparatus comprises a plurality of columns; and each column comprises an aperture array according to any preceding clause.

Clause 22: The charged particle apparatus of any of clauses 19 to 21, wherein the aperture array is within a beam area of the charged particle beam from the source.

Clause 23: A method of scanning a sample with a multi-beam of charged particles, the method comprising: generating a multi-beam of charged particles by illuminating an aperture array according to any of clauses 1 to 18 with a charged particle beam; and scanning a sample with the generated multi-beam in a plurality of continuous and partially overlapping scans.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

**Claims**

1. An aperture array configured to define sub-beams that are scanned in a scanning direction in a charged particle apparatus, the aperture array comprising a plurality of apertures arranged in an aperture pattern that comprises:

   a plurality of parallel aperture rows, wherein apertures are arranged along the aperture rows and the aperture rows are inclined relative to the scanning direction;
   an edge aperture row defining an edge of the aperture pattern; and
   an adjacent aperture row adjacent the edge row; wherein the edge aperture row and the adjacent aperture row each comprise fewer apertures than another aperture row of the aperture pattern.

2. The aperture array according to claim 1, wherein: the aperture pattern comprises a middle set of aperture rows in between two side sets of aperture rows, one of the side sets of aperture rows comprising the edge aperture row and the adjacent aperture row.

3. The aperture array according to claim 2, wherein an aperture row in one of the side sets comprise fewer apertures than an aperture row in the middle set.

4. The aperture array according to claim 2 or 3, wherein, when the aperture array is scanned relative to a target surface, an aperture row from each of the side sets cumulate together to the same as the number of apertures of an aperture row of the middle set.

5. The aperture array according to any of claims 2 to 4, wherein the distance between adjacent apertures along an aperture row of the middle set in a direction orthogonal to the scanning direction is periodic and preferably the same.

6. The aperture array according to any of claims 2 to 5, wherein the aperture rows of the middle set comprise the same number of apertures.

7. The aperture array according to any of claims 2 to 6, wherein, the aperture row of one or both of the side sets, and that is adjacent to the middle set, is an aperture row of the corresponding side set with the largest number of apertures.

8. The aperture array of claim 7, wherein the remaining rows of the corresponding side set has the same, or fewer, number of apertures than an adjacent aperture row in the direction of the middle set.

9. The aperture array according to any of claims 2 to 8, wherein along the aperture rows of the middle set there are between 5 and 5000 apertures, such as 10 or 14.

10. The aperture array according to any of claims 2 to 9, wherein along the aperture rows of the middle set there are 14 apertures; and one or both of the side sets comprise aperture rows with 10, 7 and 4 apertures respectively.

11. The aperture array according to any preceding claim, wherein the separation between adjacent apertures in two of the aperture rows differs.

12. The aperture array according to any preceding claim, wherein the aperture pattern is within a beam area; and the beam area is substantially circular or elliptical.

13. A charged particle apparatus comprising: a source of charged particles; and an aperture array according to any preceding claim, wherein:

   - the source is configured to direct a beam of charged particles towards the aperture array so that a multi-beam is emitted from the aperture array; and
   - the charged particle apparatus is arranged to scan a sample with the multi-beam in a linear scanning direction.

14. The charged particle apparatus according to claim 13, wherein the charged particle apparatus is arranged to operate in a continuous scan mode.

15. The charged particle apparatus of claim 13 to 14, wherein the aperture array is within a beam area of the charged particle beam from the source.

# Fig. 1

# Fig. 2

# Fig. 3

## Fig. 4A

## Fig. 4B

# Fig. 5A

# Fig. 5B

## Fig. 6

## Fig. 7

# Fig. 8

## Fig. 9

## Fig. 10

## Fig. 11

Fig. 12

Fig. 13

Europäisches
Patentamt
European
Patent Office
Office européen
des brevets

# EUROPEAN SEARCH REPORT

Application Number

EP 20 20 2039

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/264497 A1 (MURAKI MASATO [JP] ET AL) 10 October 2013 (2013-10-10) * paragraphs [0043], [0047]; figures 4,1 * | 1-15 | INV. H01J37/04 H01J37/317 |
| X | WO 2007/048433 A1 (ZEISS CARL SMS GMBH [DE]; PLATZGUMMER ELMAR [AT] ET AL.) 3 May 2007 (2007-05-03) * figure 3 * | 1-13,15 | |
| X | US 2012/235063 A1 (WANG WEN-CHUAN [TW] ET AL) 20 September 2012 (2012-09-20) * figure 6 * | 1-13,15 | |
| X | US 2015/348738 A1 (ZEIDLER DIRK [DE] ET AL) 3 December 2015 (2015-12-03) * paragraph [0003]; figure 3 * | 1-3 | |
| A | | 4-15 | |

TECHNICAL FIELDS
SEARCHED (IPC)

H01J

The present search report has been drawn up for all claims

| Place of search | Date of completion of the search | Examiner |
|---|---|---|
| Munich | 26 March 2021 | Oestreich, Sebastian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT**
**ON EUROPEAN PATENT APPLICATION NO.**

EP 20 20 2039

This annex lists the patent family members relating to the patent documents cited in the above-mentioned European search report.
The members are as contained in the European Patent Office EDP file on
The European Patent Office is in no way liable for these particulars which are merely given for the purpose of information.

26-03-2021

| Patent document cited in search report | | | Publication date | Patent family member(s) | | | Publication date |
|---|---|---|---|---|---|---|---|
| US 2013264497 | A1 | | 10-10-2013 | CN | 103365116 | A | 23-10-2013 |
| | | | | JP | 6128744 | B2 | 17-05-2017 |
| | | | | JP | 2013219085 | A | 24-10-2013 |
| | | | | KR | 20130112783 | A | 14-10-2013 |
| | | | | US | 2013264497 | A1 | 10-10-2013 |
| WO 2007048433 | A1 | | 03-05-2007 | AT | 424621 | T | 15-03-2009 |
| | | | | EP | 1943660 | A1 | 16-07-2008 |
| | | | | JP | 4843679 | B2 | 21-12-2011 |
| | | | | JP | 2009514200 | A | 02-04-2009 |
| | | | | US | 2009212240 | A1 | 27-08-2009 |
| | | | | WO | 2007048433 | A1 | 03-05-2007 |
| US 2012235063 | A1 | | 20-09-2012 | CN | 102683182 | A | 19-09-2012 |
| | | | | US | 2012235063 | A1 | 20-09-2012 |
| | | | | US | 2013146780 | A1 | 13-06-2013 |
| | | | | US | 2014217305 | A1 | 07-08-2014 |
| US 2015348738 | A1 | | 03-12-2015 | CN | 105206491 | A | 30-12-2015 |
| | | | | DE | 102014008083 | A1 | 17-12-2015 |
| | | | | KR | 20150138098 | A | 09-12-2015 |
| | | | | TW | 201546862 | A | 16-12-2015 |
| | | | | US | 2015348738 | A1 | 03-12-2015 |
| | | | | US | 2017133194 | A1 | 11-05-2017 |
| | | | | US | 2019088440 | A1 | 21-03-2019 |

EPO FORM P0459

For more details about this annex : see Official Journal of the European Patent Office, No. 12/82